(19) Europäisches Patentamt
European Patent Office
Office européen des brevets

(11) **EP 4 636 659 A1**

(12) **DEMANDE DE BREVET EUROPEEN**

(43) Date de publication:
**22.10.2025 Bulletin 2025/43**

(21) Numéro de dépôt: **25170018.3**

(22) Date de dépôt: **11.04.2025**

(51) Classification Internationale des Brevets (IPC):
*G06N 10/40* (2022.01)   *H03F 3/45* (2006.01)

(52) Classification Coopérative des Brevets (CPC):
**G06N 10/40; H03F 3/45475**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **17.04.2024 FR 2403977**

(71) Demandeur: **Commissariat à l'Energie Atomique et aux Energies Alternatives 75015 Paris (FR)**

(72) Inventeurs:
• **SCHMIDT, Quentin**
  **38054 GRENOBLE CEDEX 09 (FR)**
• **BADETS, Franck**
  **38054 GRENOBLE CEDEX 09 (FR)**
• **THONNART, Yvain**
  **38054 GRENOBLE CEDEX 09 (FR)**
• **JADOT, Baptiste**
  **38054 GRENOBLE CEDEX 09 (FR)**

(74) Mandataire: **Cabinet Beaumont**
  **4, Place Robert Schuman**
  **B.P. 1529**
  **38025 Grenoble Cedex 1 (FR)**

(54) **DISPOSITIF ELECTRONIQUE A APPLICATION QUANTIQUE COMPRENANT UN AMPLIFICATEUR DE LECTURE CAPACITIF**

(57)     La présente description concerne un dispositif électronique à application quantique (100) comprenant au moins :
- une boîte quantique (102) destinée à former au moins un qubit de spin ;
- un électromètre (104) couplé de manière électrostatique à un puits de potentiel de la boîte quantique (102), comprenant au moins une électrode d'entrée (106) sur laquelle un signal d'excitation est destiné à être appliqué et au moins une électrode de sortie (108) distincte de l'électrode d'entrée (106) et sur laquelle un signal de lecture est destiné à être délivré ;
- un amplificateur de transimpédance (116) à boucle de contre-réaction incluant au moins une capacité (150, 152, 154), l'amplificateur de transimpédance (116) comprenant deux entrées différentielles (118, 120) dont au moins l'une est couplée à l'électrode de sortie (108) de l'électromètre (104), et un circuit local de stabilisation de mode commun (164, 166).

**Fig. 1**

## Description

Domaine technique

La présente description concerne de façon générale le domaine de la spintronique, des dispositifs électroniques à applications quantiques et de l'informatique quantique.

Technique antérieure

L'informatique quantique est basée sur l'utilisation d'un état quantique à deux niveaux mesurables comme vecteur d'information, appelé qubit ou bit quantique ou encore « quantum bit » en anglais, et des lois de la mécanique quantique (superposition, intrication, mesure) afin d'exécuter des algorithmes. Un dispositif, ou calculateur, quantique à qubits permet de manipuler l'état quantique de ces qubits, notamment dans le but de réaliser des opérations.

Dans ces dispositifs, l'information quantique est, par exemple, codée sur le spin de charges électriques. Les technologies semi-conductrices sont utilisées pour la réalisation de qubits de spin en raison de leur haut potentiel d'intégration, à l'image de l'électronique classique. Des électrons ou des trous sont individuellement confinés dans des puits quantiques semi-conducteurs maintenus à des températures cryogéniques (généralement inférieures à 1 K) dans un cryostat et réalisés au sein de structures de confinement de tailles nanométriques définies de manière électrostatique et, dans le cas du silicium, d'architecture proche de celle des MOSFETs. Ces structures de confinement correspondent à des boîtes quantiques, également appelées « quantum dots » en anglais. Une boîte quantique se comporte comme un puits de potentiel confinant une ou plusieurs charges élémentaires (électrons ou trous) dans une région de semi-conducteur.

En raison de la température requise pour le fonctionnement des qubits, cet environnement de fonctionnement cryogénique est contraignant vis-à-vis de l'électronique de lecture des qubits lorsque celle-ci est disposée dans cet environnement : contraintes de consommation et de taille, contraintes fortes sur le bruit, minimisation du temps de lecture, maximisation de la fidélité, etc. Plusieurs solutions ont été proposées dans le but de lire un maximum de qubits dans un tel environnement : électronique de lecture disposée au plus proche des qubits et à basse température, utilisation de différents schémas et principes de lecture : par mesure de charge locale, par réflectométrie ou par impédancemétrie, etc.

Le document L. L. Guevel et al., « 19.2 A 110mK 295μW 28nm FDSOI CMOS Quantum Integrated Circuit with a 2.8GHz Excitation and nA Current Sensing of an On-Chip Double Quantum Dot »., février 2020, 2020 IEEE International Solid-State Circuits Conference, décrit une lecture de dispositifs quantiques réalisée à l'aide d'amplificateurs à transimpédance à contre-réaction résistive intégrés ou co-intégrés et placés à basse température. Un inconvénient de cette solution est la faible bande passante atteignable avec une telle architecture d'amplificateur. En conséquence, cette solution n'est pas adaptée pour la mise en œuvre d'une lecture d'un grand nombre de qubits par un même circuit de lecture.

La lecture de spin s'effectue généralement par une étape de conversion spin vers charge, comme décrit par exemple dans le document J. M. Elzerman et al., « Single-shot read-out of an individual electron spin in a quantum dot », extended version of Nature 430, 431-435, 2004, ou par blocage de Pauli par exemple. Ainsi, l'information de spin du qubit est convertie en la présence ou non d'une charge, qui peut être détectée par un électromètre.

Résumé de l'invention

Il existe un besoin de proposer un dispositif électronique à application quantique comprenant un circuit électronique de lecture de qubits configuré pour fonctionner à des températures cryogéniques, à faible consommation et à fort gain, et dont la bande passante soit compatible avec la lecture d'un grand nombre de qubits.

Un mode de réalisation pallie tout ou partie de ces inconvénients et propose un dispositif électronique à application quantique comprenant au moins :

- une boîte quantique destinée à former au moins un qubit de spin ;

- un électromètre couplé de manière électrostatique à un puits de potentiel de la boîte quantique, comprenant au moins une électrode d'entrée sur laquelle un signal d'excitation est destiné à être appliqué et au moins une électrode de sortie distincte de l'électrode d'entrée et sur laquelle un signal de lecture est destiné à être délivré ;

- un amplificateur de transimpédance à boucle de contre-réaction, la boucle de contre-réaction incluant au moins une capacité, l'amplificateur de transimpédance comprenant deux entrées différentielles dont au moins l'une est couplée à l'électrode de sortie de l'électromètre, et un circuit local de stabilisation de mode commun.

Selon un mode de réalisation particulier, l'amplificateur de transimpédance comporte un circuit d'amplification dont des entrées différentielles forment les entrées différentielles de l'amplificateur de transimpédance et incluant au moins une paire différentielle dont les grilles sont couplées aux entrées différentielles de l'amplificateur de transimpédance.

Selon un mode de réalisation particulier, le circuit local de stabilisation de mode commun est couplé entre des électrodes de sortie de la paire différentielle.

Selon un mode de réalisation particulier, le circuit d'amplification comporte en outre une charge active dont des électrodes d'entrée sont couplées à des électrodes de sortie de la paire différentielle.

Selon un mode de réalisation particulier, l'amplificateur de transimpédance comporte en outre au moins un transistor de sortie dont la grille est couplée à une sortie du circuit d'amplification, une électrode de drain du transistor de sortie formant la sortie de l'amplificateur de transimpédance.

Selon un mode de réalisation particulier, l'amplificateur de transimpédance comporte en outre une résistance couplée à l'électrode de drain du transistor de sortie formant la sortie de l'amplificateur de transimpédance.

Selon un mode de réalisation particulier, le circuit local de stabilisation de mode commun comporte au moins deux composants résistifs identiques, les deux composants résistifs correspondant à des résistances ou à des capacités commutées ou à des transistors.

Selon un mode de réalisation particulier, lorsque l'amplificateur de transimpédance comporte le circuit d'amplification et que le circuit d'amplification comporte la charge active dont des électrodes d'entrée sont couplées à des électrodes de sortie de la paire différentielle, un nœud de couplage entre les deux composants résistifs est couplé aux grilles des transistors de la charge active.

Selon un mode de réalisation particulier, lorsque l'amplificateur de transimpédance comporte le circuit d'amplification, la boucle de contre-réaction de l'amplificateur de transimpédance comporte au moins une première capacité couplée entre une sortie du circuit d'amplification et l'une des entrées différentielles correspondant à l'entrée inverseuse de l'amplificateur de transimpédance, et au moins une deuxième capacité couplée entre la sortie du circuit d'amplification et un potentiel électrique de référence.

Selon un mode de réalisation particulier, lorsque l'amplificateur de transimpédance comporte le circuit d'amplification, le circuit d'amplification comporte deux sorties différentielles chacune couplée à l'une des entrées différentielles du circuit d'amplification par la boucle de contre-réaction.

Selon un mode de réalisation particulier, le dispositif électronique à application quantique comporte en outre un cryostat dans lequel sont disposés au moins la boîte quantique, l'électromètre et l'amplificateur de transimpédance.

Selon un mode de réalisation particulier, le dispositif électronique à application quantique comprend plusieurs boîtes quantiques et plusieurs électromètres chacun couplé de manière électrostatique à un puits de potentiel de l'une des boîtes quantiques, et comprend en outre des circuits de génération de signaux d'excitation couplés aux électrodes d'entrée des électromètres et configurées pour fournir des signaux de fréquence et/ou d'amplitude et/ou de phase différentes en entrée de chacun des électromètres.

Selon un mode de réalisation particulier, un premier groupe des électromètres comporte ses électrodes de sortie couplées à une première des deux entrées différentielles de l'amplificateur de transimpédance, et un deuxième groupe des électromètres comporte ses électrodes de sortie couplées à une deuxième des deux entrées différentielles de l'amplificateur de transimpédance.

Selon un mode de réalisation particulier :

- les électromètres correspondent à des transistors à un électron ;

- les circuits de génération des signaux d'excitation sont couplés aux grilles des transistors à un électron ;

- les électrodes de sortie des électromètres correspondent aux drains des transistors à un électron et sont couplées à l'une des deux entrées différentielles correspondant à l'entrée inverseuse de l'amplificateur de transimpédance ;

et le dispositif électronique à application quantique comporte en outre un circuit d'asservissement de la tension entre la source et le drain de chacun des transistors à un électron vis-à-vis d'un potentiel électrique destiné à être appliqué sur l'autre des deux entrées différentielles correspondant à l'entrée non inverseuse de l'amplificateur de transimpédance.

Selon un mode de réalisation particulier, le dispositif électronique à application quantique comporte en outre un circuit incluant deux miroirs de courant configurés pour asservir la valeur d'un premier potentiel électrique de polarisation destiné à être appliqué sur une première des deux entrées différentielles de l'amplificateur de transimpédance à celle d'un deuxième potentiel électrique de polarisation destiné à être appliqué sur une deuxième des deux entrées différentielles de l'amplificateur de transimpédance.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

- la figure 1 représente schématiquement un exemple de dispositif électronique à application quantique selon un premier mode de réalisation ;

- la figure 2 représente schématiquement un exemple de réalisation d'un amplificateur de transimpédance à boucle de contre-réaction capacitive d'un dispositif électronique à application quantique selon le premier mode de réalisation ;

- la figure 3 représente schématiquement un exemple de réalisation d'un circuit tampon d'un dispositif électronique à application quantique ;

- la figure 4 représente schématiquement une variante de réalisation du dispositif électronique à application quantique selon le premier mode de réalisation ;

- la figure 5 représente schématiquement un exemple de dispositif électronique à application quantique selon un deuxième mode de réalisation ;

- la figure 6 représente schématiquement un exemple de réalisation d'un amplificateur de transimpédance à boucle de contre-réaction capacitive d'un dispositif électronique à application quantique selon le deuxième mode de réalisation ;

- la figure 7 représente schématiquement une variante de réalisation du dispositif électronique à application quantique selon le deuxième mode de réalisation ;

- la figure 8 représente schématiquement un exemple de circuit à double miroir de courant utilisé dans un dispositif électronique à application quantique selon un exemple de réalisation particulier.

Description des modes de réalisation

De mêmes éléments ont été désignés par de mêmes références dans les différentes figures. En particulier, les éléments structurels et/ou fonctionnels communs aux différents exemples et modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation de différents éléments et circuits (circuits électroniques de génération de signaux d'entrée, électromètres, convertisseurs analogique - numérique, circuits de démultiplexage et de démodulation, etc.) du dispositif n'est pas détaillée. L'homme du métier sera à même de réaliser de manière détaillée les différentes fonctions du dispositif à partir de la description fonctionnelle donnée ici.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés (en anglais "coupled") entre eux, cela signifie que ces deux éléments peuvent être connectés ou être reliés par l'intermédiaire d'un ou plusieurs autres éléments. En outre, dans tout le texte, les termes « couplé » et « couplage » sont utilisés pour désigner un couplage électrique entre au moins deux éléments. De même, le terme « conducteur » est utilisé pour désigner une conduction électrique.

Sauf précision contraire, les expressions "environ", "approximativement", "sensiblement", et "de l'ordre de" signifient à 10 % près, de préférence à 5 % près.

Dans la suite, il est considéré qu'une lecture de spin passe systématiquement par un mécanisme de conversion spin vers charge, dans lequel l'information de spin du qubit est convertie par la présence ou non d'une charge, qui peut être détectée par un électromètre. La description ci-dessous porte notamment sur la fidélité de lecture de la charge résiduelle après conversion.

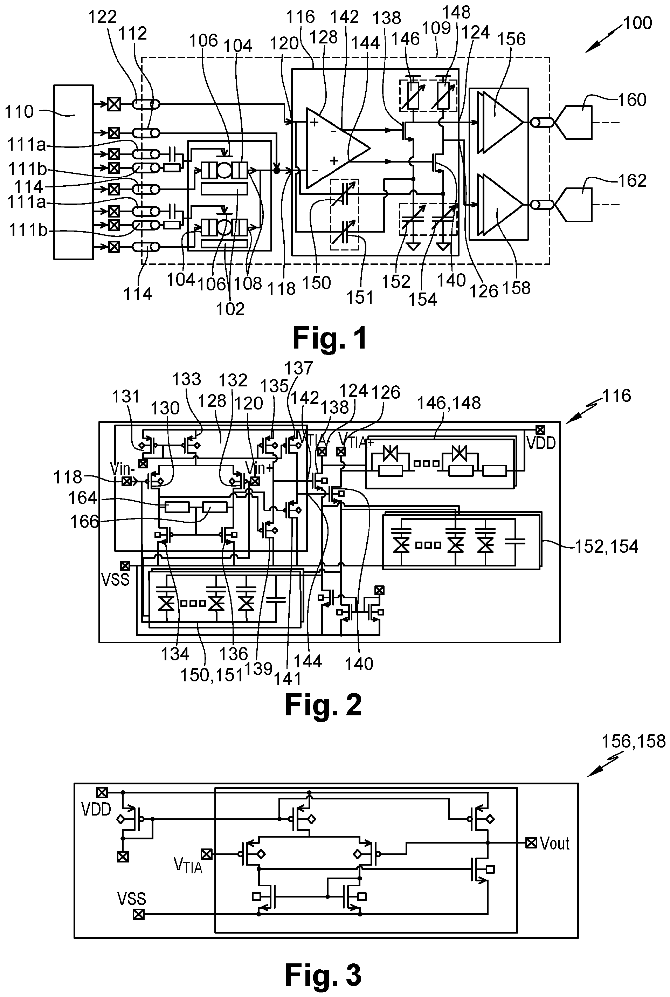

Un exemple de réalisation d'un dispositif électronique à application quantique 100 selon un premier mode de réalisation est décrit ci-dessous en lien avec la figure 1.

Le dispositif 100 comprend une ou plusieurs boîtes quantiques 102 destinées à former chacune un qubit de spin. Dans l'exemple de réalisation décrit, le dispositif 100 comprend plusieurs boîtes quantiques 102 agencées par exemple en ligne ou en colonne ou sous la forme d'une matrice. Le nombre de boîtes quantiques 102 du dispositif 100 est par exemple supérieur à 100. La ou les boîtes quantiques 102 sont par exemple réalisées dans une couche de semi-conducteur, par exemple de silicium.

Le dispositif 100 comprend en outre un ou plusieurs électromètres 104 chacun couplé de manière électrostatique au puits de potentiel de la ou de l'une des boîtes quantiques 102. Dans l'exemple de réalisation décrit, le dispositif 100 comporte plusieurs électromètres 104 chacun associé à l'une des boîtes quantiques 102. L'électromètre 104 ou chacun des électromètres 104 comporte une électrode d'entrée 106 sur laquelle un signal d'excitation est destiné à être appliqué et une électrode de sortie 108 distincte de l'électrode d'entrée 106 et sur laquelle un signal de lecture contenant l'information du spin du qubit auquel l'électromètre 104 est couplé est destiné à être délivré.

En variante, d'autres types d'électromètres comprenant une source, un drain et un nombre quelconque de grilles peuvent être utilisés pour former les électromètres 104. L'excitation peut être appliquée sur la source et/ou l'une ou plusieurs de ces grilles.

Selon un premier exemple de réalisation, chacun des électromètres 104 peut correspondre à un transistor à un électron, ou SET (« Single Electron Transistor » en anglais). Dans ce cas, l'électrode d'entrée 106 sur laquelle le signal d'excitation est destiné à être appliqué correspond à la grille et/ou la source du SET et l'électrode de sortie 108 sur laquelle le signal de lecture du qubit est destiné à être délivré correspond à l'une des électrodes de source ou de drain du SET. Dans un tel SET, une variation de courant entre sa source et son drain est créée par une variation de conductance liée à la charge électrique présente dans la boîte quantique lue.

Selon un deuxième exemple de réalisation, le ou chacun des électromètres 104 peut correspondre à un contact ponctuel quantique, ou QPC (« Quantum Point Contact » en anglais). Dans ce cas, chaque QPC comporte au moins deux électrodes (également appelées conducteurs ou régions conductrices du QPC, et qui sont disposées en vis-à-vis l'une de l'autre), au moins une première des électrodes de chaque QPC formant l'électrode d'entrée 106 du QPC et au moins une deuxième des électrodes de chaque QPC formant l'électrode de sortie 108 du QPC. Des détails de réalisation de tels QPCs sont par exemples décrits dans le document « Fast single-charge sensing with a rf quantum point contact » de D.J. Reilly et al., APPLIED PHYSICS LETTERS 91, 162101, 2007.

Le dispositif 100 comporte en outre un cryostat 109 dans lequel sont disposés les boîtes quantiques 102 et les électromètres 104. La température à laquelle sont maintenus les boîtes quantiques 102 et les électromètres 104 est par exemple inférieure ou égale à 4K, voire inférieure ou égale à 1K. Sur le schéma de la figure 1, l'environnement cryogénique du cryostat 109 est délimité symboliquement de l'atmosphère à température ambiante par des traits pointillés.

Dans l'exemple de réalisation décrit, le dispositif 100 comporte en outre des circuits électroniques 110 de génération de signaux d'entrée qui, dans cet exemple de réalisation, sont disposés en dehors du cryostat 109 et qui fonctionnent à température ambiante. Les circuits 110 incluent notamment des circuits de polarisation et de génération de signaux de fonctionnement destinés aux électromètres 104, des générateurs de fréquence, des circuits de communication, etc. Chacun des signaux émis en sortie des circuits 110 et destiné notamment aux boîtes quantiques 102 et aux électromètres 104 est amené dans le cryostat 109 par exemple par un câble. Des premières liaisons 111 permettent l'amenée de signaux d'excitation (signaux alternatifs) et de polarisation (signaux continus) en entrée des électromètres 104 (sur les grilles des SET dans cet exemple). Sur l'exemple de la figure 1, la grille de chaque SET reçoit un signal d'excitation provenant d'une première liaison 111a couplée à la grille par une capacité et un signal de polarisation provenant d'une autre première liaison 111b couplée à la grille par une résistance. En variante, il est possible d'avoir une seule première liaison 111 amenant ces deux signaux sur la grille. Une deuxième liaison 112 permet l'application d'un signal de polarisation sur les drains des SET qui sont couplés à un même nœud de couplage. Des troisièmes liaisons 114 permettent l'application de signaux de polarisation sur les sources des SET. D'autres configurations sont possibles, comme par exemple l'application des signaux d'excitation sur les sources des SET, ou bien l'amenée de signaux différents lorsque les électromètres ne correspondent pas à des SET.

Les signaux d'excitation générés par les circuits 110 et appliqués sur les grilles des SET et/ou les signaux d'entrée appliqués sur les drains des SET peuvent correspondre à des signaux périodiques tels que des signaux sinusoïdaux, carrés, triangulaires, etc. Ces signaux ont par exemple des amplitudes de quelques millivolts, et des fréquences allant de la fréquence de lecture du dispositif 100, par exemple égale à 1 MHz, jusqu'à une valeur correspondant à la bande passante du dispositif 100. La bande passante du dispositif 100 peut être définie comme étant la plage fréquentielle dans laquelle le dispositif est capable d'amplifier et de transmettre les signaux et informations utiles, sans atténuation ou avec une faible atténuation acceptable permettant tout de même leur interprétation, par exemple une baisse de gain de 3dB par rapport au gain de référence du dispositif 100. Les courants de lecture délivrés en sortie des SET ont par exemple une amplitude de l'ordre du nanoampère.

Le dispositif 100 comporte en outre un amplificateur de transimpédance 116 à boucle de contre-réaction capacitive. L'amplificateur 116 comprend deux entrées différentielles 118, 120. Sur l'exemple de la figure 1, l'amplificateur 116 comporte une première entrée inverseuse 118 couplée à des électrodes de sortie des électromètres 104 qui correspondent, dans l'exemple décrit, aux drains des SET, et une deuxième entrée non inverseuse 120 couplée, dans l'exemple décrit ici, à une quatrième liaison 122 elle-même couplée aux circuits 110 et configurée pour appliquer un potentiel de polarisation sur la deuxième entrée non inverseuse 120 de l'amplificateur 116.

Dans le premier mode de réalisation décrit, l'amplificateur 116 comporte deux sorties différentielles 124, 126, l'une correspondant à une première sortie inverseuse 126 et l'autre correspondant à une deuxième sortie non inverseuse 124.

La figure 2 représente de manière détaillée un exemple de réalisation de l'amplificateur 116.

L'amplificateur 116 comporte un circuit d'amplification 128 dont les entrées différentielles correspondent celles de l'amplificateur 116. Le circuit d'amplification 128 inclut au moins une paire différentielle active, par exemple de type MOSFET, formée par deux transistors 130, 132 dont les grilles sont couplées aux deux entrées différentielles 118, 120. Sur l'exemple de la figure 2, les potentiels appliqués sur ces deux entrées 118, 120 sont appelés $V_{in+}$ et $Vi_{n-}$. La paire différentielle comporte également deux transistors 134, 136 en charge active et dont des électrodes d'entrée sont couplées à des électrodes de sortie des transistors 130, 132 de la paire différentielle.

Sur l'exemple de la figure 2, le circuit d'amplification 128 comporte également un miroir de courant, par exemple de type MOSFET, formé par deux transistors 131, 133 et assurant la polarisation de la paire différentielle.

Sur l'exemple de la figure 2, le circuit d'amplification 128 comporte également deux transistors 135, 137 formant chacun, avec le transistor 131, un miroir de courant polarisant le second étage en drain commun du circuit d'amplification 128 disposé en sortie de la paire différentielle et formé par des transistors 139, 141. Les deux transistors 135, 137 servent également de charge active dans cet étage de drain commun. En variante, les transistors 139, 141 peuvent être montés en source commune et les transistors 135, 137 peuvent être remplacés par des charges résistives.

Selon un exemple, l'amplificateur 116 peut présenter un gain permettant d'atteindre des performances en bruit compatibles avec une lecture en courant de l'ordre du nanoampère, par exemple égal à 1000000 V/A (ou Ω). Les transistors utilisés dans le circuit d'amplification 128 peuvent être dimensionnés pour obtenir un tel gain.

Dans le premier mode de réalisation décrit, l'amplificateur 116 comporte en outre des transistors de sortie 138, 140, par exemple de type MOSFET, dont les grilles sont couplées chacune à l'une des deux sorties différentielles 142, 144 du circuit d'amplification 128. Les électrodes de drain de chacun des transistors de sortie 138, 140 forment les sorties de l'amplificateur 116. Sur l'exemple de la figure 2, les potentiels de l'amplificateur 116 délivrés sur ces sorties sont appelés $V_{TIA+}$ et $V_{TIA-}$.

Dans le premier mode de réalisation décrit, l'amplificateur 116 comporte en outre des résistances 146, 148 couplées chacune à l'électrode de drain de chacun des transistors de sortie 138, 140 formant les sorties de l'amplificateur 116. Dans l'exemple représenté sur les figures 1 et 2, les résistances 146, 148 correspondent à des résistances variables dont les valeurs sont choisies comme étant égales l'une à l'autre.

Dans le premier mode de réalisation décrit, les boucles de contre-réaction par lesquelles les deux sorties différentielles 142, 144 sont couplées chacune à l'une des deux entrées différentielles 118, 120 du circuit d'amplification 128 comportent chacune une première capacité 150, 151 couplée entre une deuxième électrode de source de chacun des transistors de sortie 138, 140 et les entrées inverseuse et non inverseuse du circuit d'amplification 128. Les transistors de sortie 140, 138 peuvent être vus comme faisant partie des boucles de contre-réaction. Chacune des boucles de contre-réaction comporte également une deuxième capacité 152, 154 couplée entre la sortie du circuit d'amplification 128 et un potentiel électrique de référence. Dans l'exemple représenté sur les figures 1 et 2, les capacités 150, 151, 152 et 154 correspondent à des capacités variables dont les valeurs sont choisies telles que celles des capacités 150, 151 soient égales l'une à l'autre, et que celles des capacités 152, 154 soient égales l'une à l'autre.

Le gain maximal de l'amplificateur 116 est fixé par les valeurs des résistances 146, 148 (appelée $R_{146,148}$) et des capacités 150, 151, 152 et 154 (appelées $C_{150,151}$ et $C_{152,154}$), et peut être exprimé par l'équation :

[Math 1]

$$Gain = \left( \frac{c_{150,151}}{c_{152,154}} + 1 \right) * R_{146,148}$$

La bande passante globale de l'amplificateur 116 dépend également, mais de manière plus complexe, de ces valeurs. Ainsi, les valeurs des résistances 146, 148 et des capacités 150, 152, 154 sont choisies en fonction du gain et de la bande passante souhaitée pour l'amplificateur 116.

Sur l'exemple des figures 1 et 2, les sorties de l'amplificateur 116 sont couplées à des entrées de circuits tampon 156, 158, ou buffers, disposés au sein du cryostat 109. Les sorties des circuits tampon 156, 158 sont couplées à des circuits de traitement de signaux par l'intermédiaire de câbles sortant du cryostat 109. Sur l'exemple de la figure 1, les sorties des circuits tampon 156, 158 sont couplées à des entrées de convertisseurs analogique - numérique 160, 162. Enfin, bien que non représentés sur les figures 1 et 2, d'autres composants et circuits servant notamment au démultiplexage des signaux de sortie sont couplés aux sorties des convertisseurs 160, 162.

Enfin, sur l'exemple de la figure 2, les potentiels électriques de polarisation utilisés dans l'amplificateur 116 sont appelés VDD et VSS.

Un exemple de réalisation d'un des circuits tampon 156, 158 est représenté sur la figure 3. Sur cette figure, la tension appliquée en entrée du circuit tampon est appelée $V_{TIA}$ et celle obtenue en sortie sur circuit tampon est appelée $V_{out}$.

Dans le premier mode de réalisation décrit, l'amplificateur 116 et les circuits tampon 156, 158 sont disposés au sein du cryostat 109. Plus particulièrement, dans l'exemple décrit, l'amplificateur 116 et les circuits tampon 156, 158 sont disposés dans la même enceinte du cryostat 109 que celle dans laquelle se trouvent les boîtes quantiques 102 et les électromètres 104. En variante, il est possible que l'amplificateur 116 et les circuits tampon 156, 158 soient disposés dans une enceinte du cryostat 109 différente et à température plus élevée (par exemple de l'ordre de 4K) que celle dans laquelle se trouvent les boîtes quantiques 102 et les électromètres 104 (température par exemple de l'ordre de 1K). D'autres répartitions des différents éléments du dispositif 100, dans ou en dehors du cryostat 109, sont possibles.

Dans le premier mode de réalisation, du fait que les sorties de l'amplificateur 116 sont différentielles, les signaux obtenus sur les sorties différentielles peuvent être soustraits l'un à l'autre, puis traités (conversion analogique - numérique, démultiplexage, etc.). En variante, il est possible d'appliquer des traitements différents sur chacun des signaux obtenus en sortie.

L'amplificateur 116 comporte en outre un circuit local de stabilisation de mode commun. Dans l'exemple de réalisation représenté sur la figure 2, le circuit local de stabilisation de mode commun comporte deux résistances électriques 164, 166 couplées entre des électrodes de sortie de la paire différentielle du circuit d'amplification 128. Dans cet exemple, chacune des résistances 164, 166 comporte une première électrode couplée à l'une des électrodes de sortie de la paire différentielle du circuit d'amplification 128 et une deuxième électrode reliée à un nœud de couplage des résistances 164, 166 qui est également couplé aux grilles des transistors 134, 136 formant la charge active de la paire différentielle du circuit d'amplification 128.

En variante de l'exemple décrit ci-dessus, le circuit local de stabilisation de mode commun peut comporter des composants autres que des résistances mais fonctionnant dans un régime résistif, c'est-à-dire dont le comportement peut être assimilé à celui des résistances 164, 166, comme par exemple des capacités commutées ou bien des transistors.

Dans l'exemple de réalisation décrit en lien avec les figures 1 et 2, le dispositif 100 comporte plusieurs boîtes quantiques 102 destinées à être lues par les électromètres 104. Les électrodes de sortie de plusieurs électromètres 104 sont couplées à l'entrée de l'amplificateur 116. Afin de pouvoir discriminer les signaux de sortie délivrés par ces électromètres 104, les circuits électroniques 110 incluent des circuits de génération de signaux configurés pour délivrer des signaux d'excitation de fréquence et/ou d'amplitude et/ou de phase différentes en entrée de chacun des électromètres 104 (sur les grilles des SET dans l'exemple précédemment décrit). Dans ce cas, un multiplexage fréquentiel et/ou d'amplitude et/ou de phase permet une lecture simultanée de plusieurs électromètres 104 par le même amplificateur 116. Dans cette configuration, les circuits de lecture couplés aux convertisseurs 160, 162 sont configurés pour pouvoir réaliser le ou les démultiplexages nécessaires à cette lecture de signaux.

Lorsqu'un multiplexage fréquentiel est utilisé pour l'excitation des électromètres 104, en raison du couplage capacitif existant entre chaque qubit et son électromètre 104 associé, il est possible de discriminer deux cas sur le courant de sortie de l'électromètre 104 : lorsque le qubit est en état |1>, la fréquence d'excitation se retrouve en sortie de l'électromètre 104 ; lorsque le qubit est en état |0>, la fréquence d'excitation est absente en sortie de l'électromètre 104. En sommant les sorties des électromètres 104 (dans l'exemple, cette sommation est obtenue en couplant les électromètres 104 à l'entrée d'un même amplificateur 116) et en attribuant à chacun une fréquence différente, après amplification, il est possible de lire plusieurs qubits en utilisant un seule paire de câbles de sortie (avec l'hypothèse que les sorties des circuits tampons 156, 158 mènent directement vers la température ambiante et que le reste du traitement y est réalisé).

Cette lecture simultanée de plusieurs électromètres 104 demande, dans le cas d'un multiplexage fréquentiel, une bande passante suffisante pour répartir en son sein les fréquences utilisées pour exciter les électromètres 104. Cette bande passante requise dépend notamment du nombre d'électromètres 104 à lire. A titre d'exemple, la bande passante de l'amplificateur 116 peut être de l'ordre de quelques dizaines de MHz. Avec une telle bande passante et un gain de 1000000 V/A afin de respecter les performances en bruit, une durée de lecture d'un qubit par l'un des électromètres 104 de l'ordre d'une microseconde est possible.

En outre, la consommation de l'amplificateur 116 est faible et par exemple de l'ordre d'une centaine de μW, ce qui rend possible la disposition de l'amplificateur 116 dans le cryostat 109 du fait que la consommation de l'amplificateur 116 peut être inférieure au budget de dissipation thermique du cryostat 109 et assez faible pour éviter une conduction de chaleur jusqu'aux boîtes quantiques 102 et aux électromètres 104.

Dans le dispositif 100, une lecture multiplexée en phase et/ou en amplitude peut venir compléter la lecture multiplexée en fréquence.

L'utilisation de l'amplificateur 116 comportant une boucle de contre-réaction capacitive permet d'avoir un gain dépendant des valeurs des capacités 150, 152, 154, celles-ci pouvant être aisément ajustées lorsque ces capacités sont programmables (comme c'est le cas sur l'exemples des figures 1 et 2).

Dans le dispositif 100, c'est la combinaison de l'utilisation d'un amplificateur de transimpédance à boucle de contre-réaction capacitive et à entrées différentielles, et du circuit local de stabilisation de mode commun, qui permet d'atteindre un meilleur compromis gain / bande passante / consommation par rapport à un amplificateur de transimpédance à contre-réaction résistive tel que précédemment décrit en lien avec l'art antérieur. D'un autre côté, c'est l'utilisation spécifique d'une paire différentielle, d'un circuit local de stabilisation de mode commun ainsi qu'un système de polarisation à deux miroirs qui permet la compatibilité de l'amplificateur à transimpédance à boucle de contre-réaction capacitive face aux contraintes de fonctionnement à température cryogénique, contrairement aux réalisations de l'état de l'art. L'utilisation des entrées différentielles permet de résoudre le problème lié au bruit de mode commun pouvant être apporté par de longs câbles traversant le cryostat du fait que seul le mode différentiel est amplifié par l'amplificateur 116. Dans le premier mode de réalisation décrit ci-dessus, il est possible de s'affranchir de la problématique liée au manque de contre-réaction DC et de la sensibilité à l'offset d'entrée via le potentiel appliqué sur l'entrée non inverseuse 118 de l'amplificateur 116. En outre, le caractère différentiel des entrées de l'amplificateur 116 peut également atténuer le bruit de mode commun présent dans les tensions de polarisation amenées à travers des câbles dans le cryostat 109.

De plus, la présence du circuit local de stabilisation de mode commun limite la sensibilité de la paire différentielle de l'amplificateur 116 aux variations des caractéristiques des transistors liées à leur fabrication (ces variations étant d'autant plus importantes que ces transistors sont utilisés à une faible température). Dans la configuration précédemment décrite, la stabilisation du potentiel électrique sur le nœud de couplage des résistances ou des composants de ce circuit permet de s'affranchir de ces problèmes. Lors du fonctionnement du dispositif 100, les transistors de la paire différentielle peuvent rester à l'état saturé et la paire différentielle ne se déséquilibre pas à la moindre asymétrie de ses transistors.

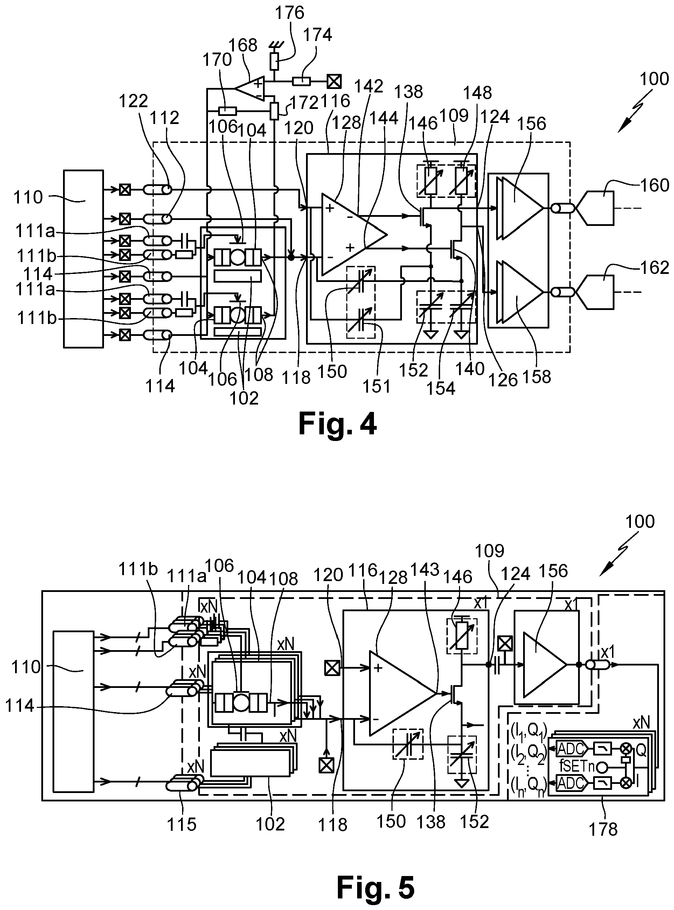

Dans le premier mode de réalisation précédemment décrit, tous les SET formant les électromètres 104 partagent le même potentiel électrique de drain. Dans une variante de réalisation représentée sur la figure 4, le dispositif 100 peut comporter, en plus des éléments précédemment décrits en lien avec les figures 1 à 3, un circuit d'asservissement de la tension entre la source et le drain (Vds) de chacun des SET. Ainsi, il est possible de stabiliser les tensions Vds des SET face aux variations du potentiel des drains des SET. En effet, un changement d'état d'un qubit peut engendrer des modifications sur la polarisation des différents électromètres 104 couplés au même nœud d'entrée. L'asservissement réalisé permet d'éviter une telle modification de polarisation lorsqu'un changement survient sur l'un des qubits. A titre d'exemple, un tel circuit d'asservissement peut correspondre à un soustracteur comprenant un amplificateur 168 configuré tel que :

- sa sortie est couplée aux sources des SET ;

- sa sortie est couplée à son entrée inverseuse par l'intermédiaire d'une première résistance 170 ;

- son entrée inverseuse est couplée aux drains des SET par l'intermédiaire d'une deuxième résistance 172 ;

- une tension de polarisation égale à la tension Vds souhaitée aux bornes des SET est appliquée sur l'entrée non inverseuse de l'amplificateur 168 à travers une troisième résistance 174 de valeur égale à celle de la deuxième résistance 172 ;

- l'entrée non inverseuse de l'amplificateur 168 est couplée à un potentiel électrique de référence à travers une quatrième résistance 176 de valeur égale à celle de la première résistance 170.

Ainsi, la tension Vds des SET est directement fixée par une polarisation externe et l'impédance de l'amplificateur 168 vue au point de jonction des drains des SET peut être maintenue à une valeur haute en choisissant des valeurs importantes, par exemple de l'ordre de $10^7$ Ohms, pour les résistances 170, 172, 174 et 176.

D'autres types et/ou configurations de circuit d'asservissement peuvent être utilisés.

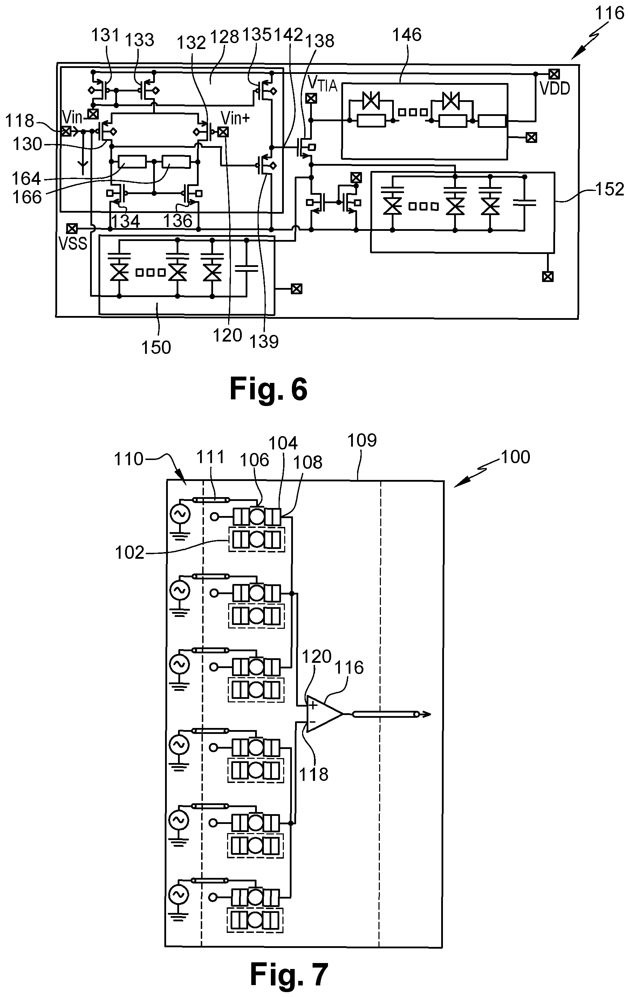

Dans le premier mode de réalisation précédemment décrit, l'amplificateur 116 du dispositif 100 comporte des sorties différentielles. Selon un deuxième mode de réalisation visible sur la figure 5, l'amplificateur 116 peut comporter une seule sortie 124 sur laquelle un signal de sortie est délivré par l'amplificateur 116. Comme dans l'exemple où l'amplificateur 116 comporte des sorties différentielles, la sortie du circuit amplificateur 128 est couplée à son entrée inverseuse par une boucle de contre-réaction similaire à celle précédemment décrite, c'est-à-dire par l'intermédiaire des capacités 150, 152 et du transistor de sortie 138. L'amplificateur 116 comporte également la résistance 146 couplée à la première électrode de drain du transistor de sortie 138. Sur la figure 5, le dispositif 100 comporte N exemplaires de chacun des éléments 111, 114, 115, 104, 102 et 178, avec N nombre entier supérieur ou égal à 1. Un exemple de réalisation détaillé de l'amplificateur 116 selon ce deuxième mode de réalisation est représenté sur la figure 6. En outre, la sortie de l'amplificateur 116 est couplée à l'entrée du circuit tampon 156. La sortie du circuit tampon 156 sort du cryostat 106 et est envoyée en entrée de circuits de démultiplexage, par exemple IQ, désignés par la référence 178.

Sur l'exemple de la figure 5, une tension de polarisation $V_{bias+}$ est appliquée sur l'entrée non inverseuse de l'amplificateur 116. En outre, dans cet exemple, la référence 115 désigne une liaison entre les circuits électroniques 110 et les boîtes quantiques 102.

Les précédentes variantes et exemples précédemment décrits peuvent s'appliquer à ce deuxième mode de réalisation.

Dans les premier et deuxième modes de réalisation précédemment décrits, les sorties des électromètres 104 sont couplées à une seule des entrées différentielles de l'amplificateur 116. Dans une variante pouvant s'appliquer à ces deux modes de réalisation, et tel que représenté schématiquement sur la figure 7 (appliquée au deuxième mode de réalisation sur cette figure), un premier groupe des électromètres 104 comporte ses électrodes de sortie couplées à une première des deux entrées différentielles de l'amplificateur 116 (trois électromètres 104 correspondant à des SET comportant leur drain couplé à l'entrée inverseuse 118 de l'amplificateur 116 sur l'exemple de la figure 7), et un deuxième groupe des électromètres 104 comporte ses électrodes de sortie couplées à une deuxième des deux entrées différentielles de l'amplificateur 116 (trois électromètres 104 correspondant à des SET comportant leur drain couplé à l'entrée non inverseuse 120 de l'amplificateur 116 sur l'exemple de la figure 7).

Cette variante de réalisation est bien adaptée pour pouvoir lire un maximum de qubits dont les électromètres de lecture 104 sont couplés parallèlement en entrée de l'amplificateur 116. En effet, l'impédance vue en entrée de l'amplificateur 116 dépend du nombre d'électromètres 104 couplés et est fonction de la relation :

[Math 2]

$$R_{NSET} = R_{SET}/N$$

avec $R_{NSET}$ correspondant à l'impédance d'entrée de N électromètres 104 couplés en parallèle, $R_{SET}$ correspondant à l'impédance de l'un des électromètres 104 et N correspondant au nombre d'électromètres 104. Or, le bruit de l'amplificateur 116 est inversement proportionnel à son impédance vue en entrée, qui est le résultat de son impédance d'entrée propre, elle-même en parallèle de $R_{NSET}$. Afin de limiter l'augmentation du bruit lié au grand nombre d'électromètres 104 couplés en entrée de l'amplificateur 116, il peut être judicieux de répartir les électromètres 104 sur les deux entrées différentielles de l'amplificateur 116. Ainsi, pour une même valeur d'impédance vue en entrée, le nombre d'électromètres 104 couplés en entrée de l'amplificateur 116 peut être doublé par rapport à une configuration où les électromètres 104 sont couplés à une même entrée de l'amplificateur 116.

Un autre avantage de cette variante de réalisation est que les entrées différentielles de l'amplificateur 116 apportent intrinsèquement un déphasage de 180° entre les signaux de sortie des électromètres 104 couplés à l'entrée inverseuse 118 et ceux des électromètres 104 couplés à l'entrée non inverseuse 120 de l'amplificateur 116. Ce déphasage peut se cumuler avec les décalages en fréquence et/ou en amplitude et/ou en phase apportés sur les signaux appliqués en entrée des électromètres 104.

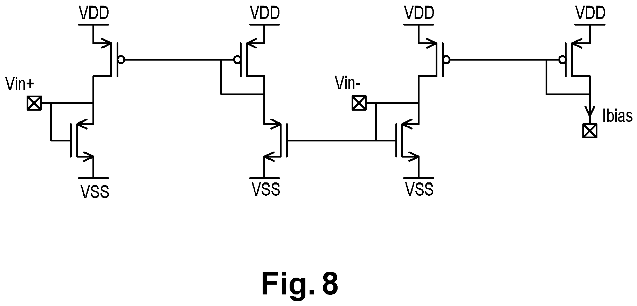

Dans les différents modes, exemples et variantes de réalisation du dispositif 100, l'amplificateur 116 peut être réalisé tel que les polarisations d'entrée $V_{in+}$ et $V_{in-}$ soient générées en utilisant un double miroir de courant, limitant ainsi les problèmes de déséquilibre liés à la variation du nœud formé sur la première entrée différentielle 118. Un exemple de réalisation d'un circuit 182 comprenant un tel double miroir de courant est représenté sur la figure 8. Dans cet exemple, la tension de polarisation $V_{in+}$ est générée à partir de la tension de polarisation $Vi_{n-}$ qui elle-même varie en fonction du courant de sortie des électromètres 104 (noté Ibias sur la figure 8) et donc de l'état des boîtes quantiques 102. Les variations sur le potentiel Vin+ se retrouvent donc sur le potentiel Vin- et sont donc transformées en signal de mode commun non amplifié par l'amplificateur 116. Cela contribue ainsi à limiter les problèmes d'amplification liés à la variation du nœud commun formé sur la première entrée différentielle 118.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus. Par exemple, la nature des dépôts et des gravures mis en œuvre peut être choisie en fonction notamment du ou des matériaux à déposer ou à graver.

**Revendications**

1. Dispositif électronique à application quantique (100) comprenant au moins :

   - une boîte quantique (102) destinée à former au moins un qubit de spin ;
   - un électromètre (104) couplé de manière électrostatique à un puits de potentiel de la boîte quantique (102), comprenant au moins une électrode d'entrée (106) sur laquelle un signal d'excitation est destiné à être appliqué et au moins une électrode de sortie (108) distincte de l'électrode d'entrée (106) et sur laquelle un signal de lecture est destiné à être délivré ;
   - un amplificateur de transimpédance (116) à boucle de contre-réaction, la boucle de contre-réaction incluant au moins une capacité (150, 152, 154), l'amplificateur de transimpédance (116) comprenant deux entrées différentielles (118, 120) dont au moins l'une est couplée à l'électrode de sortie (108) de l'électromètre (104), et un circuit local de stabilisation de mode commun (164, 166).

2. Dispositif électronique à application quantique (100) selon la revendication 1, dans lequel l'amplificateur de transimpédance (116) comporte un circuit d'amplification (128) dont des entrées différentielles forment les entrées différentielles (118, 120) de l'amplificateur de transimpédance (116) et incluant au moins une paire différentielle (130, 132) dont les grilles sont couplées aux entrées différentielles (118, 120) de l'amplificateur de transimpédance (116).

3. Dispositif électronique à application quantique (100) selon la revendication 2, dans lequel le circuit local de stabilisation de mode commun (164, 166) est couplé entre des électrodes de sortie de la paire différentielle (130, 132).

4. Dispositif électronique à application quantique (100) selon l'une des revendications 2 ou 3, dans lequel le circuit d'amplification (128) comporte en outre une charge active (134, 136) dont des électrodes d'entrée sont couplées à des électrodes de sortie de la paire différentielle (130, 132).

5. Dispositif électronique à application quantique (100) selon l'une quelconque des revendications 2 à 4, dans lequel l'amplificateur de transimpédance (116) comporte en outre au moins un transistor de sortie (138, 140) dont la grille est couplée à une sortie du circuit d'amplification (128), une électrode de drain du transistor de sortie (138, 140) formant la sortie de l'amplificateur de transimpédance (116).

6. Dispositif électronique à application quantique (100) selon la revendication 5, dans lequel l'amplificateur de transimpédance (116) comporte en outre une résistance (146, 148) couplée à l'électrode de drain du transistor de sortie (138, 140) formant la sortie de l'amplificateur de transimpédance (116).

7. Dispositif électronique à application quantique (100) selon l'une quelconque des revendications précédentes, dans lequel le circuit local de stabilisation de mode commun comporte au moins deux composants résistifs (164, 166) identiques, les deux composants résistifs (164, 166) correspondant à des résistances ou à des capacités commutées ou à des transistors.

8. Dispositif électronique à application quantique (100) selon la revendication 7, dans lequel, lorsque l'amplificateur de transimpédance (116) comporte le circuit d'amplification (128) et que le circuit d'amplification (128) comporte la charge active (134, 136) dont des électrodes d'entrée sont couplées à des électrodes de sortie de la paire différentielle (130, 132), un nœud de couplage entre les deux composants résistifs (164, 166) est couplé aux grilles des transistors de la charge active (134, 136).

9. Dispositif électronique à application quantique (100) selon l'une quelconque des revendications 2 à 8, dans lequel, lorsque l'amplificateur de transimpédance (116) comporte le circuit d'amplification (128), la boucle de contre-réaction de l'amplificateur de transimpédance (116) comporte au moins une première capacité (150) couplée entre une sortie du circuit d'amplification (128) et l'une des entrées différentielles (118) correspondant à l'entrée inverseuse de l'amplificateur de transimpédance (116), et au moins une deuxième capacité (152, 154) couplée entre la sortie du circuit d'amplification (128) et un potentiel électrique de référence.

10. Dispositif électronique à application quantique (100) selon l'une quelconque des revendications précédentes, dans lequel, lorsque l'amplificateur de transimpédance (116) comporte le circuit d'amplification (128), le circuit d'amplification (128) comporte deux sorties différentielles chacune couplée à l'une des entrées différentielles du circuit d'amplification (128) par la boucle de contre-réaction.

11. Dispositif électronique à application quantique (100) selon l'une quelconque des revendications précédentes, comportant en outre un cryostat (109) dans lequel sont disposés au moins la boîte quantique (102), l'électromètre (104) et l'amplificateur de transimpédance (116).

12. Dispositif électronique à application quantique (100) selon l'une quelconque des revendications précédentes, comprenant plusieurs boîtes quantiques (102) et plusieurs électromètres (104) chacun couplé de manière électrostatique à un puits de potentiel de l'une des boîtes quantiques (102), et comprenant en outre des circuits (110) de génération de signaux d'excitation couplés aux électrodes d'entrée (106) des électromètres (104) et configurées pour fournir des signaux de fréquence et/ou d'amplitude et/ou de phase différentes en entrée de chacun des électromètres (104).

13. Dispositif électronique à application quantique (100) selon la revendication 12, dans lequel un premier groupe des électromètres (104) comporte ses électrodes de sortie (108) couplées à une première des deux entrées différentielles (118) de l'amplificateur de transimpédance (116), et dans lequel un deuxième groupe des électromètres (104) comporte ses électrodes de sortie (108) couplées à une deuxième des deux entrées différentielles (120) de l'amplificateur de transimpédance (116).

14. Dispositif électronique à application quantique (100) selon la revendication 12, dans lequel :

- les électromètres (104) correspondent à des transistors à un électron ;
- les circuits (110) de génération des signaux d'excitation sont couplés aux grilles des transistors à un électron ;
- les électrodes de sortie (108) des électromètres (104) correspondent aux drains des transistors à un électron et sont couplées à l'une des deux entrées différentielles (118) correspondant à l'entrée inverseuse de l'amplificateur de transimpédance (116) ;

et comportant en outre un circuit (168, 170, 172, 174, 176) d'asservissement de la tension entre la source et le drain de chacun des transistors à un électron vis-à-vis d'un potentiel électrique destiné à être appliqué sur l'autre des deux entrées différentielles (120) correspondant à l'entrée non inverseuse de l'amplificateur de transimpédance (116).

15. Dispositif électronique à application quantique (100) selon l'une des revendications précédentes, comportant en outre un circuit (182) incluant deux miroirs de courant configurés pour asservir la valeur d'un premier potentiel électrique de polarisation destiné à être appliqué sur une première des deux entrées différentielles (118, 120) de l'amplificateur de transimpédance (116) à celle d'un deuxième potentiel électrique de polarisation destiné à être appliqué sur une deuxième des deux entrées différentielles (118, 120) de l'amplificateur de transimpédance (116).

**Fig. 1**

**Fig. 2**

**Fig. 3**

**Fig. 4**

**Fig. 5**

**Fig. 6**

**Fig. 7**

# Fig. 8

Europäisches Patentamt

European Patent Office

Office européen des brevets

## RAPPORT DE RECHERCHE EUROPEENNE

Numéro de la demande

EP 25 17 0018

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | L. L. GUEVEL ET AL.: "19.2 A 110mK 295µW 28nm FDSOI CMOS Quantum Integrated Circuit with a 2.8GHz Excitation and nA Current Sensing of an On-Chip Double Quantum Dot", 2020 IEEE INTERNATIONAL SOLID-STATE CIRCUITS CONFERENCE, 2020, XP033754490, | 1-12,15 | INV. G06N10/40 H03F3/45 |
| Y | * le document en entier * | 13,14 | |
| A | EP 4 057 506 A1 (HUAWEI TECH CO LTD [CN]) 14 septembre 2022 (2022-09-14) * abrégé; figure 5 * | 1,3,8 | |
| A | US 5 668 468 A (CARGILL ROBERT S [US]) 16 septembre 1997 (1997-09-16) * abrégé; figure 6 * | 1,3,8 | |
| Y | EP 4 016 402 A1 (COMMISSARIAT ENERGIE ATOMIQUE [FR]; CENTRE NAT RECH SCIENT [FR]) 22 juin 2022 (2022-06-22) * abrégé; figures 1,8 * | 13,14 | |
| A | EP 4 152 217 A1 (COMMISSARIAT ENERGIE ATOMIQUE [FR]) 22 mars 2023 (2023-03-22) * abrégé; figures 1,7,9 * | 13,14 | DOMAINES TECHNIQUES RECHERCHES (IPC) G06N H03F |
| T | SCHMIDT QUENTIN ET AL: "A 7.4[mu]W and 860[mu]m2per Channel Cryo-CMOS IC for 70-Channel Frequency-Multiplexed [mu]s-Readout of Semiconductor Qubits", 2024 IEEE CUSTOM INTEGRATED CIRCUITS CONFERENCE (CICC), IEEE, 21 avril 2024 (2024-04-21), pages 1-2, XP034604408, DOI: 10.1109/CICC60959.2024.10529081 * le document en entier * | | |

Le présent rapport a été établi pour toutes les revendications

| Lieu de la recherche | Date d'achèvement de la recherche | Examinateur |
|---|---|---|
| La Haye | 8 mai 2025 | De Meyer, Arnaud |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

                                                     

& : membre de la même famille, document correspondant

EPO FORM 1503 03.82 (P04C02)

# EP 4 636 659 A1

**ANNEXE AU RAPPORT DE RECHERCHE EUROPEENNE
RELATIF A LA DEMANDE DE BREVET EUROPEEN NO.**

EP 25 17 0018

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

08-05-2025

| Document brevet cité au rapport de recherche | Date de publication | Membre(s) de la famille de brevet(s) | Date de publication |
|---|---|---|---|
| EP 4057506 A1 | 14-09-2022 | CN 114731143 A<br>EP 4057506 A1<br>US 2022294403 A1<br>WO 2021102793 A1 | 08-07-2022<br>14-09-2022<br>15-09-2022<br>03-06-2021 |
| US 5668468 A | 16-09-1997 | AUCUN | |
| EP 4016402 A1 | 22-06-2022 | EP 4016402 A1<br>FR 3117475 A1<br>US 2022188687 A1 | 22-06-2022<br>17-06-2022<br>16-06-2022 |
| EP 4152217 A1 | 22-03-2023 | EP 4152217 A1<br>FR 3127060 A1<br>US 2023080817 A1 | 22-03-2023<br>17-03-2023<br>16-03-2023 |

EPO FORM P0460

Pour tout renseignement concernant cette annexe : voir Journal Officiel de l'Office européen des brevets, No.12/82

17

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **L. L. GUEVEL et al.** 19.2 A 110mK 295$\mu$W 28nm FDSOI CMOS Quantum Integrated Circuit with a 2.8GHz Excitation and nA Current Sensing of an On-Chip Double Quantum Dot. *2020 IEEE International Solid-State Circuits Conference*, February 2020

- **J. M. ELZERMAN et al.** Single-shot read-out of an individual electron spin in a quantum dot. *Nature*, 2004, vol. 430, 431-435
- **D.J. REILLY et al.** Fast single-charge sensing with a rf quantum point contact. *APPLIED PHYSICS LETTERS*, 2007, vol. 91, 162101